# EUROPEAN PATENT APPLICATION

(11) **EP 1 928 035 A1**
(43) Date of publication of application: **04.06.2008**
(21) Application number: 06782488.8
(22) Date of filing: 08.08.2006
(51) Int. Cl.: H01L 35/16, B22F 3/14, C22C 12/00, H01L 35/34, H02N 11/00

(54) **THERMO-ELECTRIC CONVERTING MATERIAL AND PROCESS FOR PRODUCING THE SAME**

(30) Priority: 22.09.2005 JP 2005275619
(71) Applicant: Ube Industries, Ltd., Ube-shi, Yamaguchi-ken 755-8633 (JP)
(72) Inventor: OHSORA, Yasumasa, Ube-shi, Yamaguchi, 755-8633 (JP); NAGAI, Atsushi, Ube-shi, Yamaguchi, 755-8633 (JP); TANAKA, Hisao, Ube-shi, Yamaguchi, 755-8633 (JP); FUJII, Itsuhiro, Ube-shi, Yamaguchi, 755-8633 (JP)
(74) Representative: Forstmeyer, Dietmar
(86) International application number: PCT/JP2006/315662
(87) International publication number: WO 2007/034632

(57) **Abstract**

A p or n type thermoelectric material containing, as constituent elements, at least one of Bi and Sb and at least one of Te and Se. The n type one may further contain at least one element selected from I, Cl, Hg, Br, Ag, and Cu. The thermoelectric material has a sea-island microstructure, in which the sea phase is crystal grains having an average grain size of 5 µm or smaller with their c-axes aligned unidirectionally, and the island phase is elongated crystal gains with an average length of 20 to 50 µm that are randomly distributed in the sea phase. The island phase has a microstructure in which at least one of the constituent elements is segregated. A process of producing the thermoelectric material includes mixing a sinter material with a powder having a higher Te content than the sinter material and applying heat and pressure to the mixture.

## Description

### Technical Field

This invention relates to a thermoelectric element applicable to thermoelectric power generation, thermoelectric cooling, and the like. More particularly, it relates to thermoelectric materials (p type element and n type element) which, when connected electrically in series via electrodes formed by thermal spraying to make a high performance thermoelectric module, suffer no cracking defects and cause no electrode delamination, and a process of producing the same.

### Background Art

Bi-Te based thermoelectric materials are brittle with cleavage. In particular, single crystals having the growth direction aligned in the c-axis by unidirectional solidification are liable to develop parallel cracks due to the direction of solidification (see Non-Patent Document 1). Nevertheless, c-axis alignment brings about improved electrical performance (power factor) (see Non-Patent Document 2). Hence, PIES (pulverized, intermixed element sintering) method utilizing reaction sintering has been being developed as a means to overcome the weak mechanical strength of single crystal materials (see Non-Patent Document 3) but has not succeeded as yet in achieving performance characteristics sufficient for practical use. Hot pressing furnishes a polycrystalline material, which is thought to be advantageous over single crystal materials in terms of mechanical strength because of less likelihood of cracks occurring due to cleavage. Mechanical strength can thus be improved by powder sintering. While powder sintering is accompanied by changes of thermoelectric characteristics, Seebeck coefficient and electrical conductivity can be improved by altering the material composition or the amount of a dopant (see Non-Patent Document 2). A high performance index has been reported of a Bi-Te based thermoelectric material made by hot pressing while regulating the grain size and oxygen content of the structure (see Patent Document 1). Correlation between microstructure and thermoelectric characteristics of a p type thermoelectric material is described in Non-Patent Document 4, in which a thermoelectric material having a uniform microstructure composed of crystal grains of about 10 µm is reported to have a high performance index.
The above described Bi-Te based thermoelectric materials have been used chiefly for cooling. Electrodes in thermoelectric modules for cooling (Peltier modules) are bonded by soldering. Therefore, the stress imposed on the thermoelectric material (element) is very small. Electrodes in thermoelectric modules for generation of electricity, on the other hand, are formed on the thermoelectric material (element) by thermal spraying in view of heat resistance. Accordingly, thermoelectric materials withstanding use for generation of electricity must have high performance index as well as high mechanical characteristics. When electrodes are formed by thermal spraying, and thermoelectric materials (p type and n type elements) are connected in series to make a high performance thermoelectric module, a tensile force is exerted onto the thermoelectric materials (elements) by the residual stress generated in the thermal spray coating (electrodes). Therefore, thermoelectric materials that suffer no cracking defects against the tension and cause no electrode delamination are demanded.
Non-Patent Document 1: F.D. Roise, B. Abeles and R.V. Jensen, J. Phys. Chem. Solid, No. 10 (1959), 191
Non-Patent Document 2: Kinichi Uemura and Isao Nishida, NETSUDEN HANDOTAITO SONO OHYO, Nikkan Kogyo Shinbun, Ltd., 1988
Non-Patent Document 3: Tokiai Takeo, Uesugi Takashi and Koumoto Kunihito, J. Ceram. Soc. Japan, 104 (1996), 109
Non-Patent Document 4: N. Miyashita, T. Yano, R. Tsukuda, and I. Yashima, J. Ceram. Soc. Japan, 111, (6), 2003, pp. 386-390
Patent Document 1: Japanese Unexamined Patent Application Publication No.2001-250990

### Disclosure of the Invention

Although the Bi-Te based thermoelectric material having a microstructure composed of uniformly-shaped grains has a high performance index, it encounters difficulty when applied to a thermoelectric module for generation of electricity in which the electrodes are formed by thermal spraying. That is, when a high performance thermoelectric module is produced using a thermal spraying, the thermoelectric material (element) undergoes cracking defects, which will result in separation between the thermal-sprayed electrode and the thermoelectric material (element). Such separation (delamination) of the electrode from the thermoelectric material (element) leads to disconnection of the series circuit, resulting in a failure of the function of the thermoelectric module.

Accordingly, an object of the present invention is to provide a thermoelectric material which, when fabricated into a high performance thermoelectric module by thermal spraying, suffers no cracking defects and so does not cause electrode delamination.

As a result of extensive investigations, the present inventors have found that the above object is accomplished by using a Bi-Te based electrothermal material having an island-sea microstructure.
Completed based on the above finding, the present invention provides a p type thermoelectric material containing, as constituent elements, at least one element selected from the group consisting of Bi and Sb and at least one element selected from the group consisting of Te and Se. The thermoelectric material has a sea-island microstructure. The sea phase of the sea-island microstructure is composed of crystal grains having an average grain size of 5 µm or smaller with their c-axes aligned unidirectionally, and the islands are elongated crystal gains with an average length of 20 to 50 µm. The islands are randomly distributed in the sea phase. The island phase has a microstructure in which at least one of the above recited constituent elements is segregated.
The present invention also provides an n type thermoelectric material containing, as constituent elements, at least one element selected from the group consisting of Bi and Sb and at least one element selected from the group consisting of Te and Se and optionally containing at least one element selected from the group consisting of I, Cl, Hg, Br, Ag, and Cu. The thermoelectric material has a sea-island microstructure. The sea phase of the sea-island microstructure is composed of crystal grains having an average grain size of 5 µm or smaller with their c-axes aligned unidirectionally, and the islands are elongated crystal gains with an average length of 20 to 50 µm. The islands are randomly distributed in the sea phase. The island phase has a microstructure in which at least one of the above recited constituent elements is segregated.
The present invention also provides a process of producing the thermoelectric material. The process includes the steps of mixing a sinter material with a powder having a higher Te content than the sinter material and applying heat and pressure to the mixture.

### Brief Description of the Drawing

Fig. 1 shows a crystallographic orientation distribution of a thermoelectric material according to the invention as measured by EBSP (electron backscatter diffraction pattern) analysis.
Fig. 2 is an inverse pole figure of a thermoelectric material according to the invention in the TD.
Fig. 3 shows the results of EPMA on the surface of a thermoelectric material according to the invention, in which Fig. 3(a) is an SEM image of the region under analysis;
Fig. 3(b) a distribution of Bi; and Fig.3(c) a distribution of Te.
Fig. 4 is a cross-section of a thermoelectric material of the invention having an Al electrode formed thereon by plasma spraying.
Fig. 5 is an illustration explaining how a thermoelectric material (element) of the invention is protected from cracking.
Fig. 6 is a graph of Seebeck coefficient of a Bi-Te based thermoelectric material of the invention.
Fig. 7 is a graph of electrical conductivity of a Bi-Te based thermoelectric material of the invention.
Fig. 8 is a graph showing power factor of a Bi-Te based thermoelectric material of the invention.
Fig. 9 is a graph showing thermal conductivity of a Bi-Te based thermoelectric material of the invention.
Fig. 10 is a graph showing thermoelectric dimensionless figure of merit of a Bi-Te based thermoelectric material of the invention.
Fig. 11 is a graph showing three-point bending strength of a Bi-Te based thermoelectric material of the invention.
Fig. 12 is a fracture surface of a Bi-Te based thermoelectric material of the invention after the three-point bending test.
Fig. 13 is a crystallographic orientation distribution of the Bi-Te based thermoelectric material made in Comparative Example 1 as measured by EBSP analysis.
Fig. 14 shows the results of EPMA on the surface of the Bi-Te based thermoelectric material made in Comparative Example 1, in which Fig. 14(a) is an SEM image of the area under analysis; Fig. 14(b) a distribution of Bi; and Fig.14(c) a distribution of Te.
Fig. 15 is a fracture surface of the Bi-Te based thermoelectric material of Comparative Example 1 after three-point bending test.
Fig. 16 is a cross-sectional microstructure of the thermoelectric material made in Comparative Example 1 with an Al electrode formed thereon by plasma spraying.

### Best Mode for Carrying out the Invention

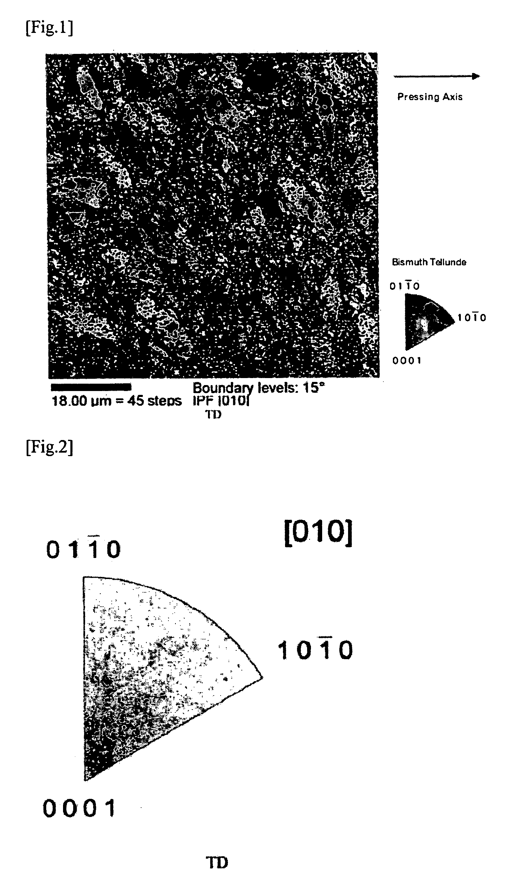

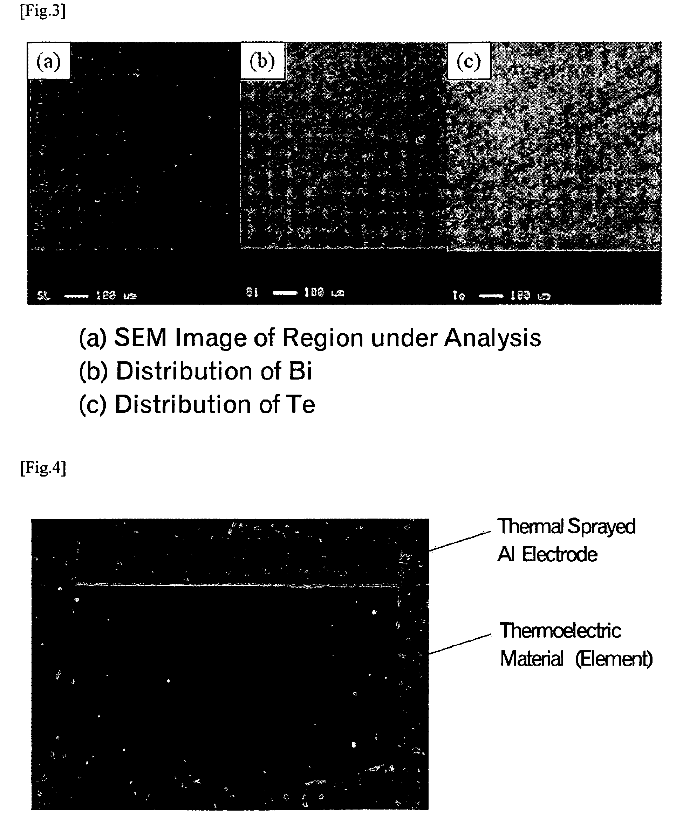

The present invention will be described based on the preferred embodiments of the thermoelectric material of the invention by referring to the accompanying drawings. Fig. 1 shows an orientation distribution of an embodiment of a typical Bi-Te based thermoelectric material according to the present invention as measured by EBSP analysis. Fig. 2 is an inverse pole figure of the thermoelectric material in the TD.
EBSP analysis is carried out by irradiating a sample set in an SEM at a tilt angle of about 70° with an electron beam. The channeling pattern generated is observed on a computer screen to measure the orientation of the crystals at the irradiated site (see B.L. Adamus, S.I. Wright, and K. Kunze, *Metall. Trans. A,* 24A (1993), 819). It is seen from Fig. 1 that the thermoelectric material of the invention has a sea phase (matrix) composed of microcrytalline grains of 5 µm or smaller in which elongated islands (disperse phase) having an average length of 20 to 50 µm are distributed at random. The inverse pole figure of the TD in this field of vision indicates that the c-axis is aligned in the direction [0001] parallel with the pressing direction. In other words, the Bi-Te based thermoelectric material has a sea-island microstructure, in which the sea phase is composed of crystal grains having an average grain size of 5 µm or smaller and with their c-axes aligned unidirectionally, and the island phase is elongated crystal grains with an average length of 20 to 50 µm that are randomly distributed in the sea phase. Fig.3 is the results of EPMA on the surface of the thermoelectric material, which obviously show segregation of Te in the island phase.

The crystal grains of the sea phase in the thermoelectric material preferably have an average size of 2 to 3 µm, and the crystal grains of the island phase preferably have an average length of 10 to 30 µm. The islands to sea ratio is preferably 20:80 to 50:50, more preferably 25:75 to 35:65.

An Al electrode was formed on the thermoelectric material by plasma spraying. A cross-sectional microstructure of the resulting sample is shown in Fig. 4. A tensile force is exerted onto the thermoelectric material (element) by the residual stress generated in the thermal spray coating (A1 electrode). It is expected, therefore, that a crack easily occurs in the thermoelectric material near the interface with the electrode. However, no cracking occurs in the material near the material/electrode interface as demonstrated in Fig. 4, proving that the material (element) suffers no delamination of the electrode.

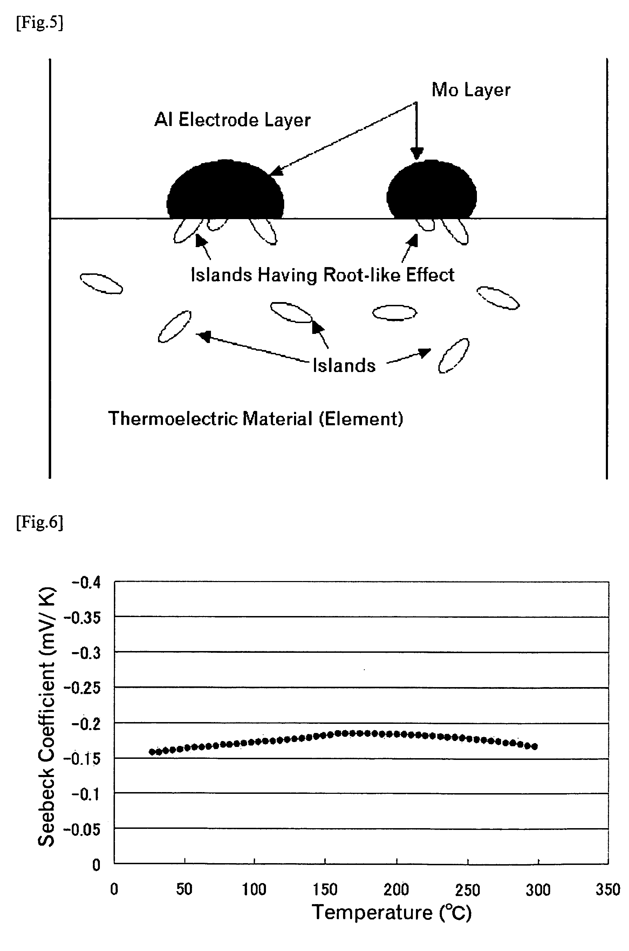

The reason why the thermoelectric material of the present invention suffers no cracking near the interface with the electrode may be explained qualitatively as follows, which by no means limits the present invention. As stated, the Bi-Te based thermoelectric material has a sea-island microstructure. When an Al electrode is formed by plasma spraying, an Mo layer is previously formed on the surface of the thermoelectric material (element) non-uniformly to a thickness of about 50 µm to enhance the adhesion between the A1 electrode and the thermoelectric material (element). The islands randomly distributed in the microstructure of the thermoelectric material (element) strongly bind to the non-uniformly discretely distributed Mo layer (or Mo lumpy particles). An Al electrode having such an Mo layer as a primer strongly binds to the thermoelectric material (element). It appears that this situation produces the same effect as if the Al electrode strikes root in the thermoelectric material (element) layer. The results of EPMA suggest that a larger amount of Te has penetrated into the Bi₂Te₃ crystal lattice of the island phase to form an interstitial solid solution than in the Bi₂Te₃ crystals of the sea phase. Penetration of Te into the interstitial sites of the Bi₂Te₃ lattice results in local lattice strain formation, and the dislocations increase in density due to the lattice strain and become entangled. As a result, the Te-rich island phase hardens. Since the thermoelectric element has a microstructure as if the Al electrode layer sets down hard roots in the thermoelectric material layer as mentioned above, the strength of the element is enhanced at and around the material-electrode interface. This is believed to be the reason the thermoelectric material (element) suffers no cracks near the material-electrode interface and so does not suffer from electrode delamination. This concept is depicted in Fig. 5.

The process of producing the thermoelectric material of the invention will then be described. Powdered starting materials are weighed out and melted to prepare an ingot that becomes a material for sinter. The ingot is ground, reduced, and classified to obtain a sinter material. Separately, an ingot having a Te-rich composition (preferably with a Te content higher by 2 to 10 mol%, more preferably by 4 to 8 mol%, than the sinter material) is prepared by melting, which is similarly ground, reduced, and classified to obtain a Te-rich powder. The Te-rich powder is mixed into the sinter material. The mixed powder is packed into a press mold and sintered under pressure in a usual manner to obtain a sintered body. The Te-rich powder particles are believed to act as nuclei of a coarse island phase.
The amount of the Te-rich powder to be mixed into 100 parts by mass of the sinter material is preferably 5 to 30 parts by mass, more preferably 8 to 20 parts by mass.

### Examples

The present invention will now be illustrated in greater detail with reference to Examples, but it should be understood that the invention is not construed as being limited thereto.

### Example 1

Raw materials were weighed out to give an atomic ratio of Bi₂Te_{2.4}Se_{0.6}, and 0.1 mass% SbI₃ was added thereto to adjust the carrier density. The mixed powder was vacuum sealed in an ampoule and melted while stirring at 650°C for 1 hour to obtain an ingot. The ingot was ground in a stamp mill and a ball mill and reduced at 390°C for 12 hours, followed by classification to obtain powder of 100 µm or smaller size as a sinter material. Separately, raw materials were weighted out at an atomic ratio of Bi₂Te_{3.0}Se_{0.6}. The mixed powder was vacuum sealed in an ampoule and melted with stirring at 650°C for 1 hour to prepare a Te-rich ingot, which was ground in a stamp mill and a ball mill, reduced at 390°C for 12 hours, and classified to obtain powder of 100 µm or smaller. The powder was mixed into the above prepared sinter material at a ratio of 10 mass%. The resulting mixed sinter material was charged into a graphite die and hot pressed at 300 kgf/cm², 410°C for 15 minutes to obtain a Bi-Te based thermoelectric material sintered body.

The sintered body was cut and polished to prepare a sample for EBSP analysis. The orientation distribution and inverse polar figure were obtained by EBSP analysis. The results obtained are shown in Figs. 1 and 2. As is apparent from these results, the sintered body has a sea-island microstructure, in which the sea phase is composed of crystal grains having an average grain size of 5 µm or smaller and with the c-axes aligned unidirectionally, and the island phase is elongated crystal grains with an average length of 20 to 50 µm that are randomly distributed in the sea phase. The results of EPMA on the surface of the sintered body are shown in Fig. 3, from which it is clear that Te is segregated in the islands.

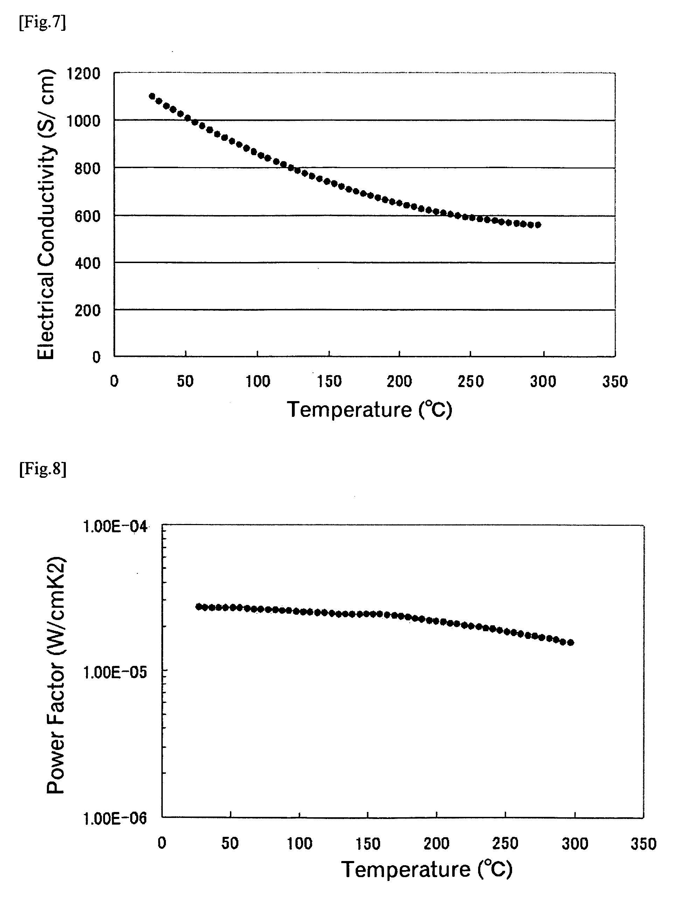

Specimens (3 mm x 20 mm, 1.5 mm (t)) cut out of the sintered body were subjected to measurements of Seebeck coefficient and electrical conductivity, and the power factor was calculated. The results obtained are shown in Figs. 6, 7, and 8, respectively. It has now revealed that the Bi-Te based thermoelectric material exhibits high performance with suppressed reduction in characteristics in high temperature.

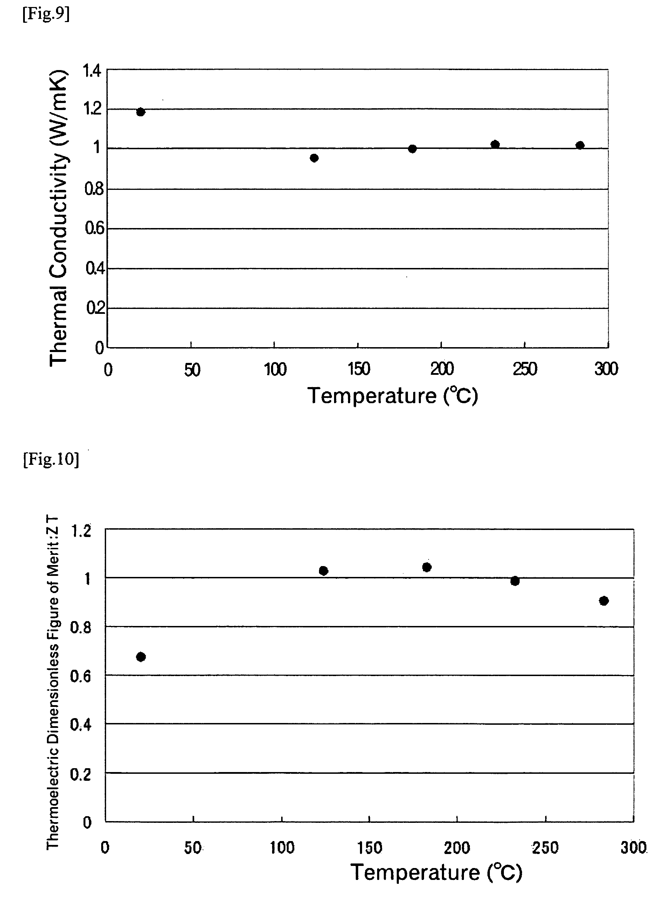

A disk specimen (d=10 mm , t=1.5 mm) cut out of the sintered body was subjected to thermal diffusivity measurement by the laser flash method. A specific heat capacity was obtained by DSC. A thermal conductivity was calculated from the thermal diffusivity, the specific heat capacity, and the density. The results are shown in Fig. 9, which demonstrate that the Bi-Te based thermoelectric material has very low thermal conductivity.

Fig. 10 shows thermoelectric dimensionless figure of merit ZT as obtained from the power factor and the thermal conductivity values. It is confirmed that the thermoelectric material is superior in thermoelectric conversion performance with ZT>1 (at up to 425K).

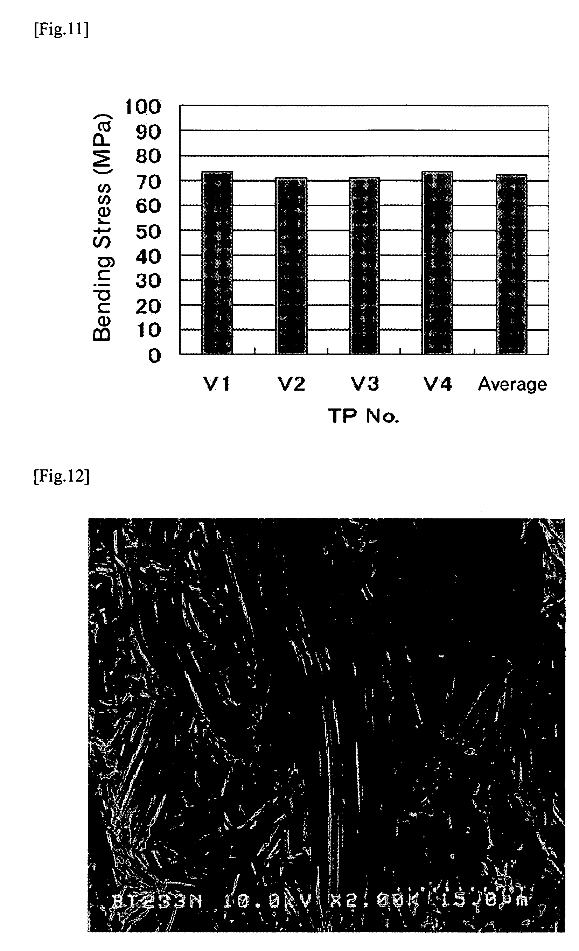

A 4 mm wide, 20 mm long, and 3 mm thick test pieces cut out of the sintered body was subjected to three-point bending test. As a result, a strength value as high as 70 MPa or higher was obtained as shown in Fig. 11. The fracture surface of the specimen after the testing is shown in Fig. 12. The results demonstrate excellent mechanical strength of the thermoelectric material.

A cylindrical specimen (d=12 mm, t=7 mm) was cut out of the sintered body. An Al electrode was formed on the upper face of the cylinder by plasma spraying. The resulting sample was cut, embedded in a resin, and polished. The structure on the polished surface was observed. The results are shown in Fig. 4. It is seen that the thermoelectric material (element) surface has no cracking defects, involving no electrode delamination. It is apparent that the Al electrode is firmly joined to the thermoelectric material (element). It has now been confirmed that the thermoelectric material (element) of the invention suffers no cracking and so does not suffer electrode delamination in the production of thermoelectric modules. The thermoelectric materials (p type and n type elements) can therefore be connected in series normally to make thermoelectric modules.

### Comparative Example 1

A Bi-Te based thermoelectric material sintered body was obtained in the same manner as in Example 1, except for using a sinter material prepared by grinding the ingot of the raw materials to powder of 50 µm or smaller in a ball mill, reducing the powder, and classifying to 50 µm or smaller (Te-rich powder was not added).

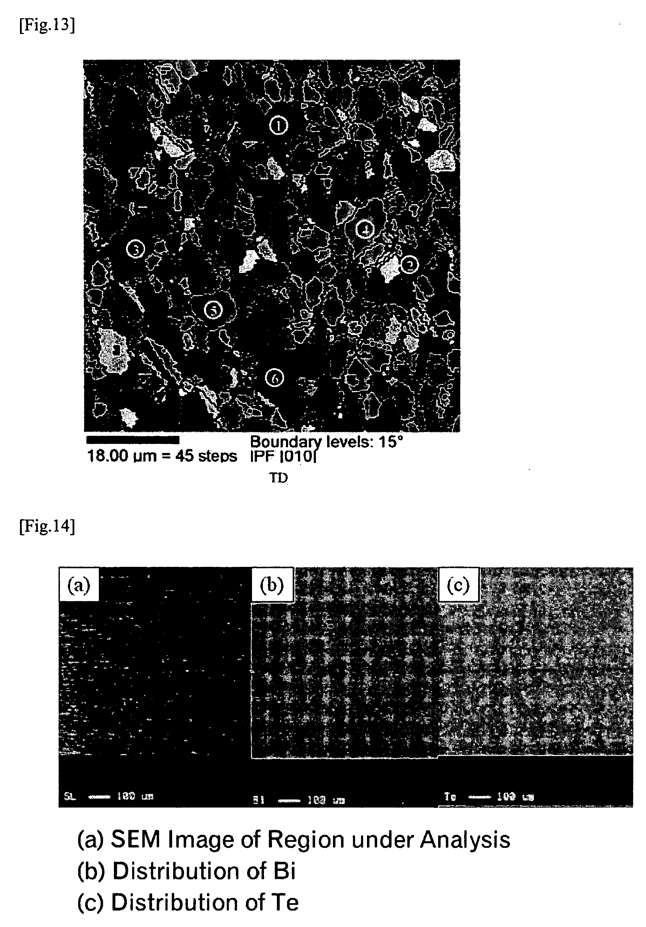

The sintered body of Comparative Example 1 was cut and polished to prepare a sample for EBSP analysis. The orientation distribution was obtained by EBSP analysis. The result is shown in Fig. 13. It is seen that there is no sea-island microstructure but a microstructure composed of uniformly dispersed crystal grains of 50 µm or smaller. Fig. 14 is the results of EPMA on the surface of the sintered body, which show uniform distribution of the constituent elements.

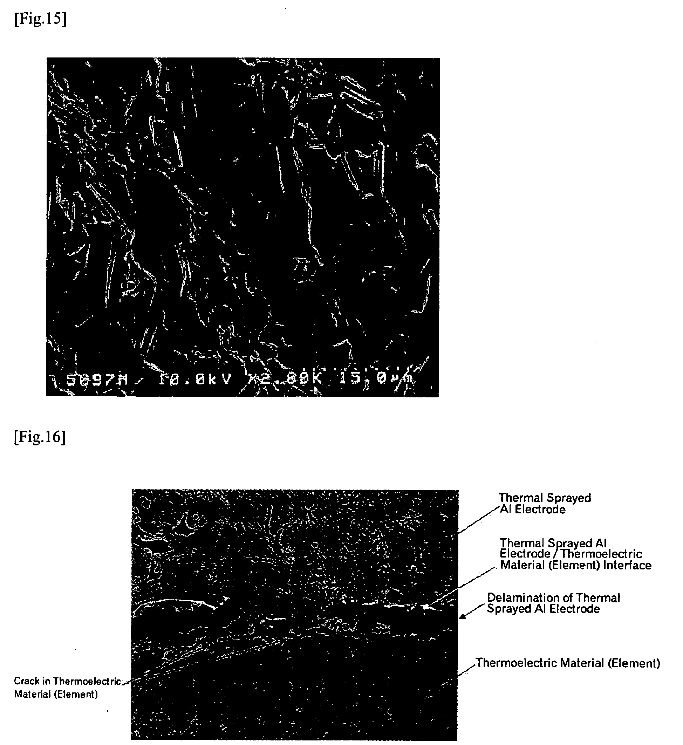

A 4 mm wide, 20 mm long, and 3 mm thick specimen cut out of the sintered body of Comparative Example 1 was subjected to three-point bending test. The fracture surface of the specimen after the testing is shown in Fig. 15. The fracture surface of uniformly distributed grains of 50 µm or smaller is observed. Intergranular fracture is also observed in parts.

A cylindrical specimen (d=12 mm, t=7 mm) was cut out of the sintered body of Comparative Example 1. An Al electrode was formed on the upper face of the cylinder by plasma spraying. The resulting sample was cut, embedded in a resin, and polished to observe the microstructure. The result is shown in Fig. 16. It is seen that cracking has occurred on the thermoelectric material (element) surface to cause delamination of the electrode. Should such electrode delamination occur in even one of the electrodes making up a thermoelectric module, it will lead to immediate disconnection of the series circuit and death of the module.

### Industrial Applicability

The thermoelectric material according to the present invention has a sea-island texture in which islands are randomly distributed in the sea phase. At least one of the constituent elements is segregated in the islands. When the thermoelectric material is assembled into a thermoelectric module by thermal spraying, the thermoelectric material (element) is protected from cracking due to the residual stress caused by the thermal spraying and so does not suffer electrode delamination.
The process of producing a thermoelectric material according to the present invention provides, through relatively simple steps, a high performance thermoelectric material that does not undergo cracking due to the residual stress of thermal spraying and so does not suffer electrode delamination.

## Claims

1. A p type thermoelectric material which comprises, as constituent elements, at least one element selected from the group consisting of Bi and Sb and at least one element selected from the group consisting of Te and Se and has a sea-island microstructure,
the sea phase comprising crystal grains having an average grain size of 5 µm or smaller with their c-axes aligned unidirectionally, and the island phase comprising elongated crystal gains with an average length of 20 to 50 µm and being randomly distributed in the sea phase, and
the island phase having a microstructure in which at least one of the constituent elements is segregated.

2. An n type thermoelectric material which comprises, as constituent elements, at least one element selected from the group consisting of Bi and Sb and at least one element selected from the group consisting of Te and Se and has a sea-island microstructure,
the sea phase comprising crystal grains having an average grain size of 5 µm or smaller with their c-axes aligned unidirectionally, and the island phase comprising elongated crystal gains with an average length of 20 to 50 µm and being randomly distributed in the sea phase, and
the island phase having a microstructure in which at least one of the constituent elements is segregated.

3. The thermoelectric material according to claim 2, which further comprises at least one element selected from the group consisting of I, Cl, Hg, Br, Ag, and Cu.

4. The thermoelectric material according to any one of claims 1 to 3, which is a Bi-Te based thermoelectric material.

5. A process of producing the thermoelectric material according to any one of claims 1 to 4, comprising the steps of mixing a sinter material with a powder having a higher Te content than the sinter material and applying heat and pressure to the mixture.
